# EUROPEAN PATENT APPLICATION

(11) **EP 4 546 431 A1**
(43) Date of publication of application: **30.04.2025**
(21) Application number: 23205383.5
(22) Date of filing: 24.10.2023
(51) Int. Cl.: H01L 29/66, H01L 21/8234, H01L 21/8238, H01L 21/822, H01L 27/06, H01L 29/775

(54) **METHOD FOR PROCESSING A CFET DEVICE WITH A NON-UNIFORM GATE DIELECTRIC**

(71) Applicant: Imec VZW, 3001 Leuven (BE)
(72) Inventor: Peter, Antony Premkumar, 3001 Heverlee (BE); Sepulveda Marquez, Alfonso, 3000 Leuven (BE); Chan, Boon Teik, 3012 Wilsele (BE); Demuynck, Steven, 3200 Aarschot (BE); Vega Gonzalez, Victor Hugo, 3001 Heverlee (BE); Petersen Barbosa Lima, Lucas, 3001 Heverlee (BE)
(74) Representative: Roth, Sebastian

(57) **Abstract**

The disclosure relates to a method for processing a complementary field effect transistor, CFET, device. The method comprises the steps of: forming at least one fin structure (23) on a substrate (14), wherein the at least one fin structure (23) comprises a horizontal top surface and two vertically oriented side surfaces between the top surface and the substrate (14), and wherein the at least one fin structure (23) comprises a first layer stack (23a) and a second layer stack (23b) above the first layer stack (23a); and forming a gate dielectric layer (41) with a nonuniform layer thickness around the at least one fin structure (23); wherein the layer thickness of the gate dielectric layer (41) which is arranged on the top surface of the at least one fin structure (23) is larger than the layer thickness of the gate dielectric layer (41) which is arranged on the side surfaces of the at least one fin structure (23).

## Description

### TECHNICAL FIELD

The present disclosure refers to a method for processing a complementary field effect transistor (CFET) device.

### BACKGROUND

In a CFET, different transistor structures, particularly NMOS and PMOS transistors, may be stacked on top of each other. Compared, for example, to a nanosheet device, which comprises NMOS and PMOS transistors arranged side by side with a spacing in between them. The stacking of the transistor structures enables increasing an effective channel width.

A key step in the CFET fabrication is the deposition of a gate oxide layer, which is typically deposited around a nanosheet (NSH) stack that contains the NMOS and PMOS channels. However, fabricating this gate oxide to wrap around the NSH stack can be challenging.

Furthermore, subsequent fabrication steps (e.g., a full gate etching step) can damage the gate oxide and the underlying NSH stack, which can reduce the CFET performance. This damaging of the NSH stack is sometimes referred to as "NSH erosion". NSH erosion is typically increased when the gate oxide layer on top of the NSH stack is relatively thin, because a thin gate oxide offers less protection to the NSH stack underneath.

### SUMMARY

Thus, it is an objective to provide an improved method for processing a CFET device. In particular, the above-mentioned disadvantages should be avoided.

The objective is achieved by the embodiments provided in the enclosed independent claims. Advantageous implementations of the embodiments of the invention are further defined in the dependent claims.

A first aspect of this disclosure provides a method for processing a complementary field effect transistor (CFET) device. The method comprises the steps of: forming at least one fin structure on a substrate, wherein the at least one fin structure comprises a horizontal top surface and two vertically oriented side surfaces between the top surface and the substrate, and wherein the at least one fin structure comprises a first layer stack and a second layer stack above the first layer stack; and forming a gate dielectric layer with a non-uniform layer thickness around the at least one fin structure; wherein the layer thickness of the gate dielectric layer which is arranged on the top surface of the at least one fin structure is larger than the layer thickness of the gate dielectric layer which is arranged on the side surfaces of the at least one fin structure.

This provides the advantage that the fin structure can be efficiently protected from damage during subsequent fabrication steps. This is due to the increased layer thickness of the gate dielectric on the top surface of the fin structure, where subsequent fabrication steps (e.g., a full gate etch) would cause the most damage. In particular, so-called NSH erosion of the layers within the fin structure can be reduced.

The thicker gate dielectric layer on the top surface can serve as a protective layer for the fin structure, while the layer thickness of the gate dielectric layer on the side surfaces of the fin structure can be reduced to a level which allows accessing and/or performing further processing steps in the space between two adjacent fin structures (e.g., a gate oxide breakthrough step).

The top surface of the fin structure can be an area on the fin structure which wraps around a tip of the fin structure, wherein most or all of the top surface is facing away from the substrate. For instance, the top surface of the fin structure is tapered (i.e., not fully flat). The vertical side surfaces can be surfaces of the side walls of the fin structure.

The gate dielectric layer can be a gate oxide (Gox) layer.

Hereby, processing the CFET device may refer to fabricating or manufacturing the CFET device.

In an embodiment, the layer thickness of the gate dielectric layer which is arranged on the top surface of the at least one fin structure is between 1.5 and 3 times larger than the layer thickness of the gate dielectric layer which is arranged on the side surfaces of the at least one fin structure.

This achieves the advantage that the gate dielectric layer on top of the fin structure can serve as an additional protection layer to prevent NSH erosion.

In an embodiment, the gate dielectric layer is a silicon dioxide (SiO₂) layer.

In an embodiment, the gate dielectric layer is deposited on the at least one fin structure by means of a layer deposition technique, such as plasma enhanced atomic layer deposition (PEALD) or pulsed chemical vapor deposition (CVD).

In an embodiment, the gate dielectric layer is thereby formed on the top surface of the at least one fin structure with a different film quality than on the side surfaces of the at least one fin structure.

Hereby, different film quality may refer to a different (e.g., higher) film density related with and/or dielectric stoichiometry and composition of the gate dielectric layer at the top surface of the fin structures compared to the side surfaces. This can result in a higher film stability (e.g., chemical stability) of the gate dielectric layer on the top surface compared to the gate dielectric layer on the side surfaces.

In particular, a non-conformal / non-uniform deposition of the gate dielectric layer can be realized by a single deposition step, e.g. in contrast to a conformal/uniform deposition with additional plasma treatments. For instance, the dielectric layer can be deposited on the top surface of the fin structure with a higher deposition rate than on the side surfaces during the same deposition process.

In an embodiment, after deposition, the layer thickness of the gate dielectric layer around the at least one fin structure is reduced by means of an etching step.

This etching step can generate and/or enhance the difference in layer thickness between the gate dielectric layer on the top surface and the side surfaces of the fin structure. For instance, the etching step can be a wet etching with an hydrofluoric acid (HF) solution.

In an embodiment the etching step has a higher etching rate on the gate dielectric layer which is arranged on the side surfaces of the at least one fin structure than on the gate dielectric layer which is arranged on the top surface of the at least one fin structure.

This can be due to the high film quality and/or stability of the gate dielectric layer on the top surface compared to the gate dielectric layer on the side surfaces of the fin structure.

Thus, a step coverage control with a post-wet treat can result in a thickness modulation of the gate dielectric layer around the 3D topography of the fin structure and/or to non-conformal depositions for tight pitch fin structures, e.g., for CFET FEOL integration. Hereby, the non-conformal deposition may refer to a loading of the fin structure with a thickness difference between the top surface (thicker gate dielectric) and the side walls (thinner gate dielectric).

In an embodiment, the method comprises the further step of: selectively adapting, in particular densifying, the gate dielectric layer which is arranged on the top surface of the at least one fin structure.

In this way, the film quality and/or stability of the gate dielectric layer on the top surface can be further enhanced.

In an embodiment, the step of selectively adapting the gate dielectric layer is carried out directly after a deposition of the gate dielectric layer or directly prior to a full gate etching step.

In an embodiment, the selective adaptation of the gate dielectric layer is carried out by any one of the following techniques: plasma treatment, UV treatment or annealing.

In an embodiment, an array of two or more fin structures is generated simultaneously.

In an embodiment, the method comprises the further step of: forming at least one gate structure on or around the at least one fin structure.

The gate structure can be a fin-like structure which is arranged perpendicular to the fin structure. The gate structure can be a dummy gate structure. The dummy gate structure can be replaced in a later step by a replacement metal gate structure.

In an embodiment, the first layer stack comprises at least one channel layer of a first transistor structure of the CFET device, and the second layer stack comprises at least one channel layer of a second transistor structure of the CFET device.

The first (or bottom) transistor structure can be arranged in a first tier (or level) and the second (or top) transistor structure can be arranged in a second tier (or level) of the CFET device, wherein the second tier is arranged above the first tier. This may result in stacked transistor structures of the CFET device. The CFET device may comprise further transistor structures or other elements, which could respectively be directly above or beneath the first and second transistor structure.

For instance, the first transistor structure and the second transistor structure can form a CFET cell. The CFET device can comprise one or more CFET cells or parts thereof.

Notably, in this disclosure the terms "below" and "above", "bottom" and "top", or similar terms are to be interpreted relative to each other. In particular, these terms describe opposite sides of the CFET device, or opposite side of any element of the CFET device. The terms may describe a relationship of elements (e.g., transistor structures, signal routing lines, power rails, etc.) of the CFET device along the direction of stacking of the tiers (or levels) of the CFET device. The stacking direction may thus align with the arrangement of the two tiers (or even more than two tiers) of the CFET device. That is, the two or more tiers (or levels), which are arranged above each other, are arranged one after the other along a certain direction (the stacking direction).

A transistor structure in this disclosure may be or may comprise a transistor, for example a field effect transistor (FET), or may be or may comprise a more complex semiconductor-based structure, which functions like a transistor. For instance, the semiconductor-based structure may be a nanosheet structure, a fin structure, or a forksheet structure, for example, provided with a gate partly wrapping around or fully wrapping around channel portions. The latter may be for instance a gate-all-around structure.

The transistor structures of the CFET device of the first aspect may be NMOS and PMOS transistor structures. For instance, the first transistor structure may be an NMOS transistor structure and the second transistor structure a PMOS transistor structure, or vice versa.

In an embodiment, the method comprises the further steps of: forming a first source and/or drain structure which is in electrical contact with the first layer stack of the at least one fin structure; and forming a second source and/or drain structure which is in electrical contact with the second layer stack of the at least one fin structure.

For instance, the source and/or drain structures are formed by an epitaxial growth process.

A second aspect of this disclosure provides a CFET device obtainable by the method according to the first aspect of this disclosure.

Such a CFET device produced with the method of the first aspect of the disclosure shows clear "fingerprints" of that method. For instance, an electronic microscope image of a cross-section of the CFET device can reveal the different layer thicknesses of the gate dielectric layer on the top surface and the side surfaces of the fin structure.

### BRIEF DESCRIPTION OF THE DRAWINGS

The above described aspects and implementations are explained in the following description of embodiments with respect to the enclosed drawings:
- FIGS. 1A-D: show steps of a method for processing a CFET device according to an embodiment;
- FIGS. 2A-B: show a step of a method for processing a CFET device according to an embodiment; and
- FIGS. 3A-B: show a step of a method for processing a CFET device according to an embodiment.

### DETAILED DESCRIPTION OF EMBODIMENTS

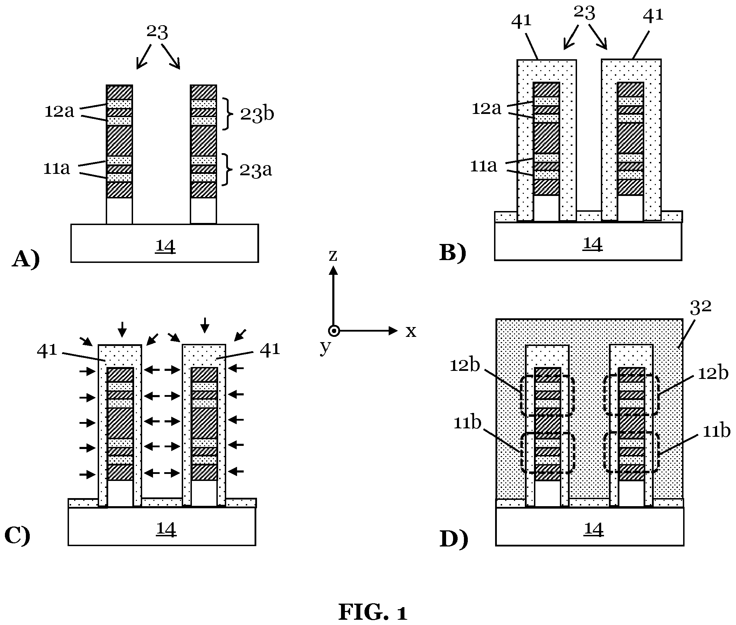

FIGS. 1A-D show steps of a method for processing a CFET device according to an embodiment. FIGS. 1A-D thereby show cross-section views through an x-z plane (as indicated by the Cartesian coordinate system), which is perpendicular to a channel direction (y-direction) of the CFET device.

In the example shown in FIGS. 1A-D, two structures with the same basic elements are processed side by side. These two structures can form different CFET devices or different CFET cells or components of a single CFET cell. A CFET device may be a unit of the CFET cell, wherein unit means that the CFET device could be repeated one or more times in the CFET cell. In particular, identical elements of the two structures (and of further, not shown structures) can be formed simultaneously. In the following, processing steps that can be identical for both structures are usually described with reference to only one (or to at least one) of the structures.

In a first step, shown in FIG. 1A, the method comprises forming at least one fin structure 23 on a substrate 14, wherein the at least one fin structure comprises a horizontal top surface and two vertically oriented side surfaces between the top surface and the substrate 14.

The at least one fin structure 23 comprises a first layer stack 23a and a second layer stack 23b above the first layer stack 23a.

The first layer stack 23a may comprise at least one channel 11a of a first transistor structure of the CFET device and the second layer stack 23b may comprise at least one channel 12a of a second transistor structure of the CFET device. For instance, the first transistor structure is a bottom transistor structure and the second transistor structure is a top transistor structure of the CFET device. The bottom transistor structure can be a NMOS and the top transistor structure can be a PMOS, or vice versa.

The first and second layer stack 23a, 23b can be arranged directly on top of each other. Each layer stack 23a, 23b can comprise a plurality of alternating layers, comprising at least one channel layer (e.g., a Si layer) and at least one dielectric layer. For instance, each layer stack 23a, 23b can comprise alternating Si and SiGe layers. A top layer of the fin structure 23 can be a Si₃N₄ layer. A dielectric separation layer stack (e.g., middle dielectric isolation, MDI) can be arranged between the first and second layer stack 23a, 23b. For instance, the separation layer stack can comprise a SiGe layer (with high %Ge) which was originally a part of the Si/SiGe layer stack 23a, 23b and is converted to a dielectric in a subsequent step. However, the dielectric separation layer stack can also be a part of the first or the second layer stack 23a, 23b, e.g. in case of embedded MDI.

The fin structure 23 can be formed on a substrate 14 by active nanosheet patterning, e.g. by patterning of a nanosheet stack on the substrate 14. The nanosheet stack can comprise the layer stacks 23a, 23b and the dielectric separation layer stack.

As shown in FIGS. 1B and 1C, the method further comprises forming a gate dielectric layer 41 with a non-uniform layer thickness around the at least one fin structure 23. Thereby, the layer thickness of the gate dielectric layer 41 which is arranged on the top surface of the at least one fin structure 23 is larger than the layer thickness of the gate dielectric layer which is arranged on the side surfaces of the at least one fin structure 23.

The gate dielectric layer 41 can be a gate oxide layer, such as a silicon dioxide (SiO₂) layer.

The gate dielectric layer 41 can be deposited around the fin structure 23 in a first step, shown in FIG. 1B. For instance, the gate dielectric layer 41 can thereby be deposited by means of a layer deposition technique, such as plasma enhanced atomic layer deposition (PEALD), or a pulsed chemical vapor deposition (CVD).

Subsequently, the layer thickness of the gate dielectric layer 41 can be reduced by means of an etching step, as shown in FIG. 1C. Thereby, the gate dielectric layer 41 on the side surfaces of the fin structure 23 can be etched with a higher etching rate than the gate dielectric layer 41 on the top surface of the fin structure 23 (the etching is indicated by arrows in FIG. 1C). In this way, a gate dielectric layer 41 with a non-conformal (i.e., non-uniform) layer thickness around the fin structure 23 can be generated, wherein the layer thickness on the top surface of the fin structure 23 is larger than on the side surfaces.

For example, the layer thickness of the gate dielectric layer 41 which is arranged on the top surface of the at least one fin structure 23 is between 1.5 and 3 times larger than the layer thickness of the gate dielectric layer 41 which is arranged on the side surfaces of the at least one fin structure 23.

This non-conformal layer thickness of the gate dielectric 41 can be advantageous in different integration schemes and modules. For instance, the thicker dielectric layer 41 on the top surface of the fin structure 23 can serve as a protective layer during subsequent processing steps. In this way, for instance, so-called NSH erosion effects can be reduced. Furthermore, a reduced layer thickness on the side surfaces of the fin structure 23 can provide more room for downstream integration applications between the adjacent fins, in particular when using high aspect ratio fin structures 23 with tight spacing between the lines.

The gate dielectric layer 41 could be directly deposited as a non-conformal layer, i.e., with a higher layer thickness on the top surface compared to the side surfaces of the fin structure 23. This non-conformity can then be further enhanced by means of the etching step (shown in FIG. 1C).

Alternatively, the gate dielectric layer 41 can be deposited as a uniform (conformal) layer with a (mostly) uniform layer thickness and the non-conformity can be generated by means of the etching step (shown in FIG. 1C).

The etching step can be a wet etching with hydrofluoric acid (HF). Thereby, a concentration of the HF and/or an etching time can be adjusted to achieve target layer thicknesses on the top and side surfaces.

For instance, during deposition (shown in FIG. 1B), the gate dielectric layer 41 is formed on the top surface of the at least one fin structure 23 with a different film quality than on the side surfaces of the at least one fin structure. Thereby, different film quality may refer to different (higher) film density and/or dielectric stoichiometry (and composition) at the top surface of the fin structure 23 compared to the side surfaces. In particular, the gate dielectric layer 41 on the top surface can be deposited with a higher film stability compared to the gate dielectric layer 41 on the side surfaces.

This increased film quality (e.g., density, stability) of the gate dielectric layer 41 on the top surface can cause a lower etching rate on this portion of the gate dielectric layer 41 during the etching step (FIG. 1C), compared to the gate dielectric layer 41 that is arranged on the side surfaces. In other words, due to a higher film quality of the dielectric layer 41 on the top surface, less material is removed during etching at this area. In contrast, the gate dielectric layer 41 that is arranged on the side surfaces of the fin structure 23 can be etched with a higher etching rage (i.e., more material is removed) due to its lower film stability.

Furthermore, the concentration of the etchant and/or the etching time can be adapted to achieve target layer thicknesses on the top and side surfaces. In an example, the etching rate of the gate dielectric layer 41 with an HF solution can be 2-10 nm/min at the top surface and 3-30 nm/min at the side surfaces (depending on the HF concentration). The resulting gate dielectric layer can have a thickness of >5 nm on the top surface and <4 nm on the side surfaces.

Thus, by taking advantage of conformal or non-conformal gate dielectric films 41 deposited, for example, by PEALD and a suitable wet treat (e.g., with HF), the thickness of the gate dielectric 41 can be tuned at the side walls and at the top of the fin structure 23. This tuning can be supported by varied film qualities on the top and the side surfaces of the fin structure 23 possibly obtained in the deposited state.

The gate dielectric layer 41 may further be formed on the substrate 14 in an area between two adjacent fin structures 23. The layer thickness of the gate dielectric layer 41 on the substrate 14 could also be larger than the layer thickness on the respective side surfaces of the fin structures 23. The extend of this effect might depend on the spacing and aspect ratio of the fin structures 23.

As shown in FIG. 1D, the method can further comprise: forming at least one gate structure 32 on or around the at least one fin structure 23. The gate structure 32 can be a dummy gate structure which is replaced by a replacement metal gate in a later step. The gate structure 32 can be formed on the gate dielectric layer 41.

Furthermore, as shown in FIG. 1D, the method can comprise: forming a first source and/or drain structure 11b which is in electrical contact with the first layer stack 23a of the at least one fin structure 23; and forming a second source and/or drain structure 12b which is in electrical contact with the second layer stack 23b of the at least one fin structure 23.

In particular, the source or drain structures 11b, 12b (also referred to as: source or drain terminals 11b, 12b) can be arranged to electrically contact the channel(s) 11a, 12a of the first layer stack 23a or the second layer stack 23b, respectively. For instance, the source or drain terminals 11b, 12b can be formed by means of an epitaxial growth process on or around the channel(s) 11a, 12a.

Prior to forming the source and/or drain structures 11b, 12b, the fin structure 23 can be partially removed to expose the channels 11a, 12a.

The source and/or drain terminals 11b, 12b are indicated by dashed boxes in FIG. 1D, these terminals are typically arranged offset in channel direction (y-direction) with respect to the gate structure 32 (i.e., in front of and/or behind the gate structure 32 shown in FIG. 1D).

In further steps of the method, which are not shown in FIGS. 1A-D, contact structures can be formed which electrically contact the first and/or the second source or drain terminals 11b, 12b. For instance, the source or drain terminals 11b, 12b can be contacted from the side by contacting structures. Source or drain terminals of transistors of neighboring CFETs can be connected by signal routing structures (e.g. side routing structures).

Furthermore, power rails (e.g., a VDD and a VSS power rail) can be formed that contact the first transistor structure respectively the second transistor structure. In addition, a set of signal routing lines of the CFET device can be formed in a metal layer above the transistor structures, and can be connected to the first and the second transistor structure.

The method shown in FIGS. 1A-D allows for an increased step coverage control and the formation of a non-conformal gate dielectric layer for high aspect ratio (AR) CFET applications (e.g., CFETs with high aspect ratio fin structures 23). Having thicker dielectric films at the top surface of the fin structures 23 compared to the side walls can be advantageous in CFET applications. For instance, the gate dielectric layer 41 being thicker at the top surface of the fin structure 23 can be advantageous for landing the full gate etch and, in particular, for avoiding NSH erosion. At the same time, the gate dielectric layer 41 being thinner on the side walls of the fin structure 23 can be better for a gate oxide breakthrough step to e.g. access a sacrificial SiGe layer of the layer stack(s) 23a, 23b and, hence, for its removal, e.g. for middle dielectric isolation (MDI) fill. A too thick gate dielectric layer 41 on the side walls of the fin structures 23 could further lead to a deleterious shallow trench isolation (STI) attack and, thus, to the removal of the STI.

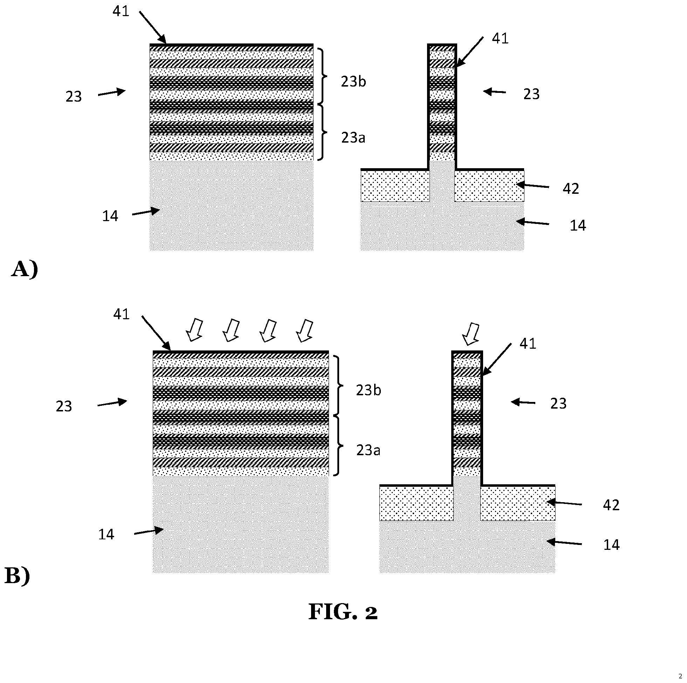

FIGS. 2A-B show a further, optional step of the method for fabricating the CFET device. The step is a selective adaption of the gate dielectric layer 41 which is arranged on the top surface of the at least one fin structure 23.

This step can be carried out after formation of the gate dielectric layer 41, e.g. directly after the layer deposition shown in FIG. 1B.

The left drawing in FIG. 2A shows a cross-section view of the fin structure 23 through an y-z plane (along a fin extension direction /channel direction) and the right drawing in FIG. 2A shows a cross-section view of the fin structure 23 through a x-z plane (perpendicular to a fin extension direction / channel direction) after the gate dielectric layer deposition. Thereby, the internal first and second layer stack 23a, 23b can be seen.

The substrate 14 between the fin structures 23 can be covered by a shallow trench isolation (STI) layer 42.

The adaption of the gate dielectric layer 41 is indicated by arrows in the drawings of FIG. 2B. For instance, the adaption can be a densification of the layer 41. This adaption (e.g., densification) being "selective" means that only a part of the gate dielectric layer 41, namely the part that is arranged on the top surface of the fin structure 23, is treated.

This adaptation can further enhance the stability of the gate dielectric layer 41 on the top surface of the fin structure 23. Consequently, the gate dielectric layer 41 on the top surface can be more robust during subsequent fabrication steps. For instance, a NSH erosion during a full gate etching (FGE) soft landing attack can be further reduced.

The partial removal of dummy gate material at the FGE can be done by patterning the gate material, comprising: (1) depositing and patterning a hard mask layer above the dummy gate using single-or multiple-patterning techniques), and (2) thereafter the dummy gate layer maybe etched, e.g. using a dummy gate hard mask as an etch mask, using a dry (plasma) etch. When dummy material is etched down to the bottom of the fins, the risk of also eroding the top surface of the gate oxide such that the underlying nanosheets of the channels are attacked is avoided by the thicker (and adapted) top part of the gate oxide (gate dielectric layer 41). In later steps, this remaining gate oxide directly below the dummy gate structures can be completely removed and replaced by a final gate dielectric (e.g., HfO₂, during a replacement metal gate step).

The selective adaptation of the gate dielectric layer 41 can be carried out using one or more of the following techniques: a plasma treatment, a UV treatment or an annealing of the gate dielectric layer 41.

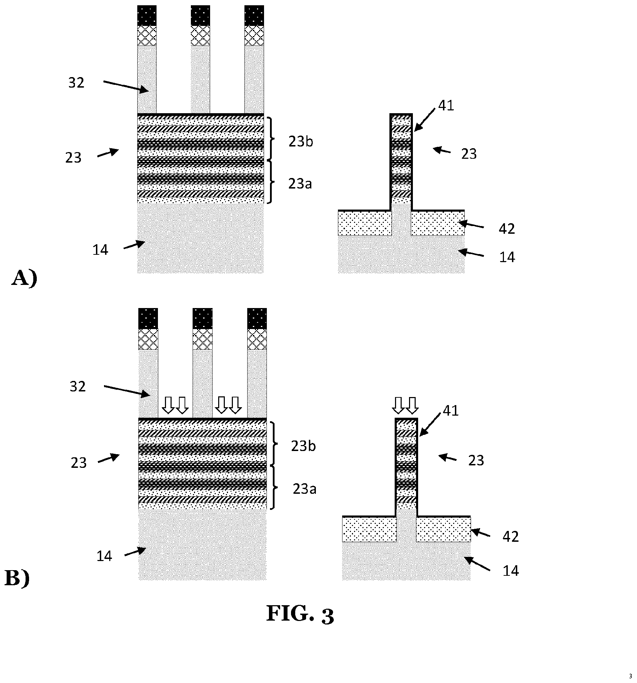

FIGS. 3A-B show further cross-section views of a fin structure 23 during a later stage of the fabrication process, namely after formation of the dummy gate structure 32.

Thereby, FIG. 3B shows the selective adaption of of the gate dielectric layer 41 being carried out after the dummy gate formation but prior to the full gate etch. The treatment (e.g., densification) of the gate dielectric layer 41 on the top surface of the fin structure 23 is indicated by arrows in the right drawing.

The (dummy) gate structure 32 can be formed from aSi (amorphous silicon). The aSi material can comprise a silicon nitride (Si₃N₄) and silicon oxide (SiOₓ) layer on top.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A method for processing a complementary field effect transistor, CFET, device, comprising the steps of:
forming at least one fin structure (23) on a substrate (14), wherein the at least one fin structure (23) comprises a horizontal top surface and two vertically oriented side surfaces between the top surface and the substrate (14), and wherein the at least one fin structure (23) comprises a first layer stack (23a) and a second layer stack (23b) above the first layer stack (23a); and
forming a gate dielectric layer (41) with a non-uniform layer thickness around the at least one fin structure (23);
wherein the layer thickness of the gate dielectric layer (41) which is arranged on the top surface of the at least one fin structure (23) is larger than the layer thickness of the gate dielectric layer (41) which is arranged on the side surfaces of the at least one fin structure (23).

2. The method of claim 1,
wherein the layer thickness of the gate dielectric layer (41) which is arranged on the top surface of the at least one fin structure (23) is between 1.5 and 3 times larger than the layer thickness of the gate dielectric layer (41) which is arranged on the side surfaces of the at least one fin structure (23).

3. The method of claim 1 or 2,
wherein the gate dielectric layer (41) is a silicon dioxide, SiO₂, layer.

4. The method of any one of the preceding claims,
wherein the gate dielectric layer (41) is deposited on the at least one fin structure (23) by means of a layer deposition technique, such as plasma enhanced atomic layer deposition, PEALD, or pulsed chemical vapor deposition, CVD.

5. The method of claim 4,
wherein the gate dielectric layer (41) is thereby formed on the top surface of the at least one fin structure (23) with a different film quality than on the side surfaces of the at least one fin structure (23).

6. The method of claim 4 or 5,
wherein, after deposition, the layer thickness of the gate dielectric layer (41) around the at least one fin structure (23) is reduced by means of an etching step.

7. The method of claim 6,
wherein the etching step has a higher etching rate on the gate dielectric layer (41) which is arranged on the side surfaces of the at least one fin structure (23) than on the gate dielectric layer (41) which is arranged on the top surface of the at least one fin structure (23).

8. The method of any one of the preceding claims, further comprising the step of:
selectively adapting, in particular densifying, the gate dielectric layer (41) which is arranged on the top surface of the at least one fin structure (23).

9. The method of claim 8,
wherein the step of selectively adapting the gate dielectric layer (41) is carried out directly after a deposition of the gate dielectric layer (41) or directly prior to a full gate etching step.

10. The method of claim 8 or 9,
wherein the selective adaptation of the gate dielectric layer (41) is carried out by any one of the following techniques: plasma treatment, UV treatment or annealing.

11. The method of any one of the preceding claims, further comprising the steps of:
forming at least one gate structure (32) on or around the at least one fin structure (23).

12. The method of any one of the preceding claims,
wherein the first layer stack (23a) comprises at least one channel layer (11a) of a first transistor structure of the CFET device, and wherein the second layer stack (23b) comprises at least one channel layer (12a) of a second transistor structure of the CFET device.

13. The method of claim 12, further comprising the steps of:
forming a first source and/or drain structure (11b) which is in electrical contact with the first layer stack (23a) of the at least one fin structure (23); and
forming a second source and/or drain structure (12b) which is in electrical contact with the second layer stack (23b) of the at least one fin structure (23).

14. A complementary field effect transistor, CFET, device obtainable by the method according to any one of the preceding claims.
